Europäisches Patentamt

European Patent Office

Office européen des brevets

(19)

(11) Numéro de publication: **0 138 638**
A2

(12) # DEMANDE DE BREVET EUROPEEN

(21) Numéro de dépôt: 84401642.8

(22) Date de dépôt: 07.08.84

(51) Int. Cl.⁴: **H 01 L 29/80**, H 01 L 29/78, H 01 L 29/10

(30) Priorité: 17.08.83 FR 8313392

(43) Date de publication de la demande: 24.04.85
Bulletin 85/17

(84) Etats contractants désignés: DE GB IT NL

(71) Demandeur: THOMSON-CSF, 173, Boulevard
Haussmann, F-75379 Paris Cedex 08 (FR)

(72) Inventeur: Raulin, Jean-Yves, THOMSON-CSF
SCPI 173, bld Haussmann, F-75379 Paris Cedex 08 (FR)
Inventeur: Hirtz, Jean-Pierre, THOMSON-CSF
SCPI 173, bld Haussmann, F-75379 Paris Cedex 08 (FR)
Inventeur: Poulain, Pierre, THOMSON-CSF SCPI 173, bld
Haussmann, F-75379 Paris Cedex 08 (FR)
Inventeur: Devol, Guy, THOMSON-CSF SCPI 173, bld
Haussmann, F-75379 Paris Cedex 08 (FR)

(74) Mandataire: Taboureau, James et al, THOMSON-CSF
SCPI 173, Bld Haussmann, F-75379 Paris Cedex 08 (FR)

(54) Transistor à effet de champ à grille ultra-courte et à structure horizontale, et son procédé de fabrication.

(57) L'invention concerne un transistor à effet de champ pour circuits intégrés hyperfréquences: les métallisations d'électrodes (17, 18, 19) d'un même côté de la pastille, et la grille est submicronique. L'invention concerne également le procédé de réalisation de la grille ultra-courte.

Le transistor comporte trois couches, tampon (11), d'accès (12) et d'isolement (13) supportées par un substrat (10). La région de commmande, constituée par au moins une couche active (15) et une métallisation de grille (17) est formée dans un sillon (14) qui pénètre jusqu'à la couche tampon (11), mais sans la traverser. Seule la partie du sillon (14) dans la couche tampon (11) est active en tant que grille de commande. La réalisation du sillon se fait par voie chimique, en s'appuyant sur les plans cristallographiques des couches.

Application aux circuits intégrés hyperfréquences.

EP 0 138 638 A2

# TRANSISTOR A EFFET DE CHAMP A GRILLE ULTRA-COURTE ET A STRUCTURE HORIZONTALE, ET SON PROCEDE DE FABRICATION

La présente invention concerne un transistor à effet de champ, doté d'une structure de grille en forme de V, et dont la longueur de grille est déterminée par la longueur de pénétration de la pointe du V dans une couche de matériau semiconducteur, voisine de la couche active du transistor. La structure de ce transistor est horizontale, ce qui permet de disposer des métallisations d'accès et de commande sur une même face d'un circuit intégré par exemple. L'invention concerne également le procédé de réalisation de ce transistor, procédé selon lequel il est aisé d'obtenir des grilles de longueur bien inférieure au micron, ce qui rend le transistor à effet de champ selon l'invention plus particulièrement adapté aux très hautes fréquences.

Pour pouvoir réaliser des circuits intégrés fonctionnant dans les hyperfréquences, qui requièrent des performances élevées, il s'avère nécessaire de savoir réaliser un transistor à effet de champ présentant une longueur de grille submicronique. Les méthodes actuellement connues et utilisées, en particulier par photolithogravure, ne permettent pas d'obtenir des définitions très élevées ; réalisée par photolithogravure, une grille de transistor d'un micron de longueur est à peu près la limite de la technologie. D'autres méthodes telles que l'usinage par faisceaux d'électrons donnent de meilleurs résultats, mais elles nécessitent des moyens technologiques complexes donc coûteux et qui ne sont pas appropriées à des réalisations industrielles de grande série.

Le procédé selon l'invention permet de définir des grilles de longueur ultra-courte, 2000 à 4000 Å de longueur étant un chiffre moyen, par un procédé technologiquement simple, très bien contrôlable et reproductible, et qui permet de réaliser un composant, transistor à effet de champ, dans lequel le transport se fait à deux dimensions (TEGFET) ou à trois dimensions.

L'invention reprend une structure connue selon laquelle la longueur de grille est contrôlée par l'épaisseur d'une couche épitaxiée, la grille étant creusée en V dans les couches semiconductrices. Cependant, le transistor selon l'invention est différent du V MOS en ce que :

- la longueur de grille est déterminée par la pénétration de la pointe du V, qui est seule électriquement active, dans une couche épitaxiée,

- la couche active du transistor à effet de champ est elle-même épitaxiée dans le V.

Cette structure est obtenue par un procédé simple d'attaque chimique qui, à condition de respecter les coupes cristallographiques du matériau de départ, permet d'obtenir des grilles de 2000 Å de longueur par exemple bien plus facilement qu'avec les moyens généralement employés, complexes et coûteux.

De façon plus précise l'invention concerne un transistor à effet de champ, à grille ultra-courte et à structure horizontale, comportant, supportées par un substrat, au moins une première couche d'un matériau semiconducteur à grande bande interdite, recouverte par une seconde couche d'un matériau semiconducteur à petite bande interdite, ces deux couches formant une mésa sur les flancs de laquelle sont déposées deux métallisations d'électrodes d'accès, source et drain, ce transistor étant caractérisé en ce que la région de contrôle, constituée par la couche active et au moins la métallisation de grille est formée dans un sillon, qui sépare la seconde couche en deux régions d'accès à la couche active, et qui pénètre dans la première couche, la longueur de pénétration dudit sillon dans la première couche constituant la longueur de grille du transistor.

La structure du transistor selon l'invention et son procédé de réalisation qui fait partie de l'invention, seront mieux compris par la description d'un exemple de réalisation, cette description s'appuyant sur les figures jointes en annexe qui représentent :

- figure 1 : vue en coupe d'un transistor V MOS selon l'art connu,

- figure 2 : vue en coupe d'un transistor à effet de champ à grille submicronique selon l'invention,

- figure 3 : schéma simplifié du sillon en V, mettant en évidence les plans cristallographiques du matériau,

- figures 4 à 10 : principales étapes de réalisation d'un transistor à effet de champ par le procédé selon l'invention.

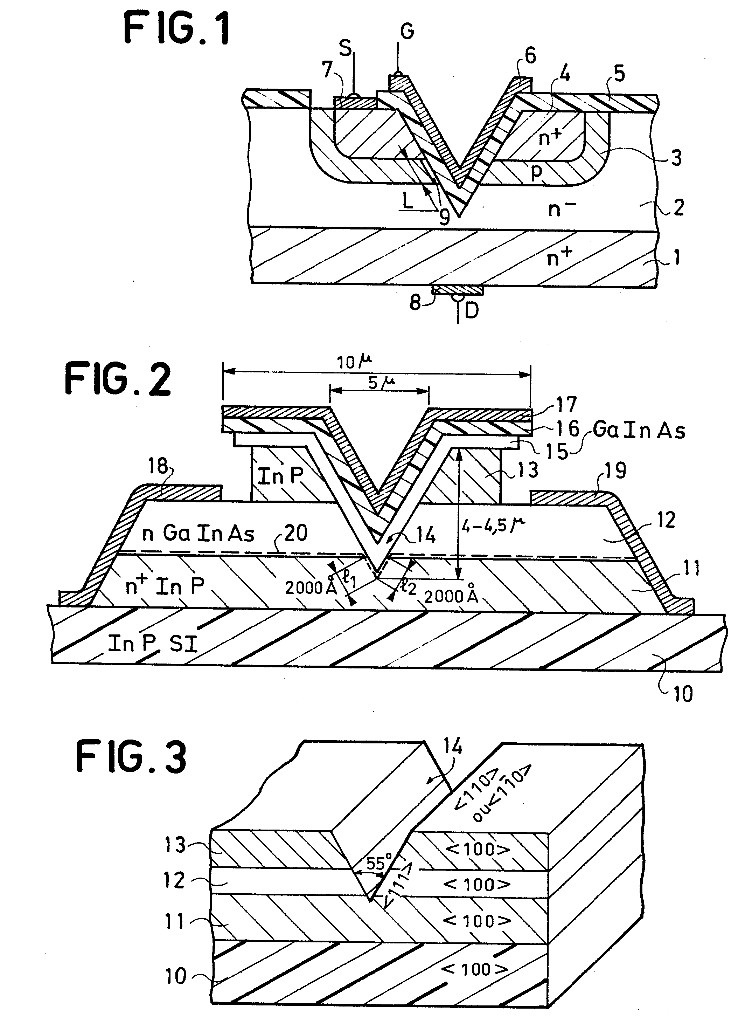

La figure 1 représente la vue en coupe d'un transistor V MOS selon l'art connu ; elle a pour objet de bien marquer la différence existant entre le transistor V MOS qui trouve des applications essentiellement dans ledomaine des transistors de puissance, et le transistor selon l'invention dont l'application est plutôt réservée aux très hautes fréquences puisque sa grille peut être amplement submicronique.

Le transistor V MOS est une transposition verticale du transistor à double diffusion D MOS. Il comporte un substrat 1 de type de dopage $n^+$ sur lequel on a fait croître une couche épitaxiée 2 de type $n^-$, faiblement dopée. Dans cette couche 2, une première diffusion donne un caisson 3 de type p, puis une seconde diffusion donne un caisson 4 de type $n^+$, diffusé à l'intérieur du premier caisson 3. Une attaque chimique profonde permet de réaliser un sillon en forme de V et ce sillon doit largement dépasser la profondeur du caisson p. Une couche d'isolant, de silice $SiO_2$ par exemple puisqueles V MOS sont généralement réalisés sur silicium, permet de protéger la surface de la pastille du transistor mais également d'isoler la métallisation de grille 6 qui est rapportée dans le V. Une métallisation de source 7 est déposée sur une première face du transistor, et cette métallisation est en contact avec le caisson 4 de type $n^+$. Une seconde métallisation de drain 8 est déposée sur la seconde face de la pastille du transistor, c'est-à-dire côté substrat. Un transistor V MOS tel que celui de la figure 1 fonctionne donc en vertical, c'est-à-dire que le courant se déplace de la source vers le drain transversalement aux couches épitaxiées : le canal 9 qui a été symbolisé sur la figure correspond à la partie commune entre la couche d'oxyde dans le sillon en V et l'épaisseur restante du caisson 3 de type p, cette épaisseur s'étendant entre la couche 2 de type $n^-$ et le caisson 4 de type $n^+$. La longueur du canal symbolisé par la flèche L correspond donc à l'épaisseur entière d'une couche. Il n'est donc pas possible, lorsque les couches ont été épitaxiées puis diffusées, de choisir ou de modifier la longueur du canal d'un V MOS.

Par ailleurs, le V MOS, très intéressant comme transistor de puissance rapide, présente l'inconvénient d'avoir des métallisations sur ses deux faces puisqu'il a une structure verticale et fonctionne verticalement : pour réaliser des circuits intégrés rapides, il est préférable d'utiliser des composants à structure horizontale de telle sorte que toutes leurs métallisations se trouvent sur une même face de la pastille de circuit intégré.

C'est l'un des objets du transistor selon l'invention que de réaliser des transistors très rapides, ayant une structure horizontale, c'est-à-dire toutes leurs métallisations d'un même côté de la pastille de matériaux semiconducteurs, de façon à pouvoir réaliser des circuits intégrés. C'est en outre un objet de l'invention que de présenter une méthode de réalisation simple et aisée permettant d'obtenir des grilles de longueur très courte, cette méthode permettant en outre d'adapter la longueur de grille, et de la corriger éventuellement pour l'augmenter si nécessaire, ce que ne permet pas le procédé de réalisation des transistors V MOS.

La figure 2 représente une vue en coupe d'un transistor à effet de champ selon l'invention. Le transistor à effet de champ selon l'invention peut être réalisé dans différentes configurations :

- le sillon peut être en forme de V ou en forme hémi-cylindrique,

- les matériaux peuvent être de genre InP, Ga In As, ou GaAs.GaAl As, ou d'autres matériaux encore bien connus dans les associations des matériaux de la famille III-V,

- le type de transistor peut être lui-même à transport bi-dimensionnel, c'est-à-dire un TEGFET (Two Dimensional Electron Gas Field Effect Transistor) ou tri-dimensionnel comme les transistors classiques,

- la structure de grille peut être de type à jonction JFET, ou de type MESFET.

Pour simplifier les explications, et préciser les figures, l'invention sera décrite sur le cas d'un transistor réalisé avec des matériaux InP/ Ga In As, à transfert bi-dimensionnel, et à structure de grille de type MESFET isolé. Cependant, la précision apportée par cet exemple de réalisation ne limite en rien la portée de l'invention qui s'adresse de façon plus générale à tous les transistors à effet de champ pour lesquels on désire réaliser facilement une grille de longueur très courte largement submicronique.

Le transistor selon l'invention est réalisé sur un substrat 10 en InP semi-isolant. Cet InP est orienté selon une coupe ⟨100⟩ de l'orientation cristallographique du matériau de départ. Le transistor comporte une première couche 11 en InP de type $n^+$, dopée à $5.10^{17} - 10^{18}$ électrons $cm^{-3}$, d'épaisseur 2000 Å environ. Cette couche 11 est une couche tampon, mais elle fournit les électrons à la couche 12, qui lui est directement adjacente. Cette couche 12 est en Ga In As, de type n, dopée à $10^{15}$, ce qui équivaut à dire qu'elle est non intentionnellement dopée : de façon plus générale la couche 11 est une couche d'un matériau à grand gap et la couche 12 est une couche d'un matériau à petit gap. Sur la couche 12 est réalisée, toujours par épitaxie, une couche 13 en InP non dopée : elle constitue une couche "d'isolement' qui permet une sous-gravure sous la couche active, et éloigne la couche active des électrodes d'accès, pour éviter les court-circuits, comme cela sera expliqué ultérieurement. L'épaisseur totale de la couche 13 + la couche 12 + une partie de la couche 11, c'est-à-dire jusqu'à la pointe du sillon en V qui sera décrit ultérieurement, peut facilement atteindre 4 à 4,5 microns.

Dans les couches superficielles 13 en InP, 12 en GaInAs et, partiellement, 11 en InP, est creusé un sillon 14 en forme de V. La pointe de ce sillon doit pénétrer légèrement dans la couche tampon 11, et le détail en sera donné ultérieurement.

Dans le sillon 14, et à la surface libre de la couche 13 InP sont déposées par les moyens appropriés selon la nature du matériau trois couches 15 de Ga In As, 16 d'oxyde ou de matériaux semiconducteurs et 17 de métal.

La couche 15 de Ga In As constitue la couche active du transistor à effet de champ. Elle est obtenue par épitaxie en phase vapeur ou par jets moléculaires : si le transistor est un transistor de type TEGFET tel que celui décrit en figure 2, elle a environ 2000 Å d'épaisseur et elle est en matériau non dopé ; si le transistor est un transistor à transfert tri-dimensionnel, c'est-à-dire un JFET ou MESFET classique, elle a environ 3000 Å d'épaisseur et est dopée à $10^{17}$ électrons par $cm^3$.

La couche 16 est une couche d'oxyde, ou une couche d'un matériau semiconducteur si l'on veut faire un transistor à effet de champ à jonction JFET. Enfin, la couche 17 constitue la métallisation de prise de contact de grille du transistor.

La structure du transistor selon l'invention est précisée par le fait que les couches 11 et 12 sont taillées en mésa, et qu'elles comportent deux métallisations de source 18 et de drain 19, sur les côtés du mésa, et en

0138638

6

contact direct avec le nuage d'électrons à deux dimensions, symbolisé par une ligne pointillée 20, à l'interface entre les couches 11 et 12. La couche 12 de Ga In As est coupée en deux par le sillon creusé à partir de la surface et qui atteint la couche tampon 11 : les deux parties de cette couche 12 situées respectivement à droite et à gauche du sillon sur la figure 2 constituent les couches d'accès à la couche active.

Dans la structure de transistor selon l'invention, seule la partie de la pointe du sillon qui pénètre dans la couche tampon 11 constitue la grille, dont la longueur est égale à la somme des deux longueurs $l_1$ et $l_2$, définies par la pointe de ce sillon dans la couche tampon 11. Pour donner une idée des facilités apportées par le transistor selon l'invention pour obtenir une grille dont la longueur est égale à 4000 Å, c'est-à-dire la somme $l_1 = 2000$ Å et $l_2 = 2000$ Å, il suffit d'ouvrir dans les couches épitaxiées, 11, 12 et 13, un sillon dont la base, à hauteur de la surface externe de la couche 13, est de l'ordre de 5 microns, ce qui est très facilement réalisé par photolithogravure. Si après masquage d'un sillon de 5 microns de large l'attaque a lieu sur 4 à 4,5 microns d'épaisseur, la longueur de grille obtenue est très facilement et très nettement inférieure à 1 micron. De plus, cette structure permet de réaliser une métallisation de grille dont la largeur est de l'ordre de 10 microns, ce qui se fait facilement.

On peut remarquer sur la figure 2 que les couches 15 de Ga In As et 13 d'InP sont sous-gravées par rapport aux couches métalliques 17 et d'isolant 16. Cette sous-gravure n'est pas indispensable au fonctionnement du transistor ou à la mise en oeuvre de son procédé de réalisation : néanmoins, elle facilite grandement la réalisation du transistor car elle permet d'utiliser le mésa inversé formé par les couches 13, 15, 16 et 17 comme masque pour la réalisation des métallisations de source 18 et de grille 19 qui sont auto-alignées par rapport à la métallisation de grille 17. La réalisation de ces sous-gravures sera explicitée ultérieurement à l'occasion du procédé de réalisation du transistor selon l'invention.

La figure 3 représente un schéma simplifié du sillon en V, mettant en évidence les plans cristallographiques du transistor selon l'invention.

Le substrat 10 étant taillé selon une orientation $\langle 100 \rangle$ du matériau de départ, les couches 11, 12 et 13 que l'on fait croître par épitaxie sur le substrat 10 sont elles-mêmes également orientées selon une coupe $\langle 100 \rangle$ . Pour réaliser facilement le transistor selon l'invention, il est nécessaire de respecter une orientation du sillon en V 14 selon une coupe $\langle 110 \rangle$ ou $\langle 110 \rangle$ : à partir du moment où le masquage du sillon en V 14 respecte cette orientation cristallographique, l'attaque chimique des couches 13, 12 et 11 s'opère facilement et s'auto-limite à un angle de 55°, les deux faces du sillon en V 14 butant, en quelque sorte, contre les coupes $\langle 111 \rangle$ des couches épitaxiées.

Pour réaliser un tel sillon en V, il est nécessaire que l'attaque chimique soit non sélective, c'est-à-dire qu'elle ait la même vitesse d'attaque vis-à-vis de la couche d'InP 13, de la couche de Ga In As 12, et de la couche d'InP 11. Des solutions connues sont par exemple les solutions de HBr + $Br_2$ + H2O dans les proportions de 1-20-100, ou de 1-17-35. Il a été dit précédemment que le sillon en V 14 peut être remplacé par d'autres sillons, d'autres formes : l'important étant de limiter la longueur de grille à une faible pénétration dans une couche de matériau tampon, la forme du sillon n'est pas le plus important, et d'autres techniques pour réaliser des attaques hémi-cylindriques par exemple font partie du domaine de l'invention.

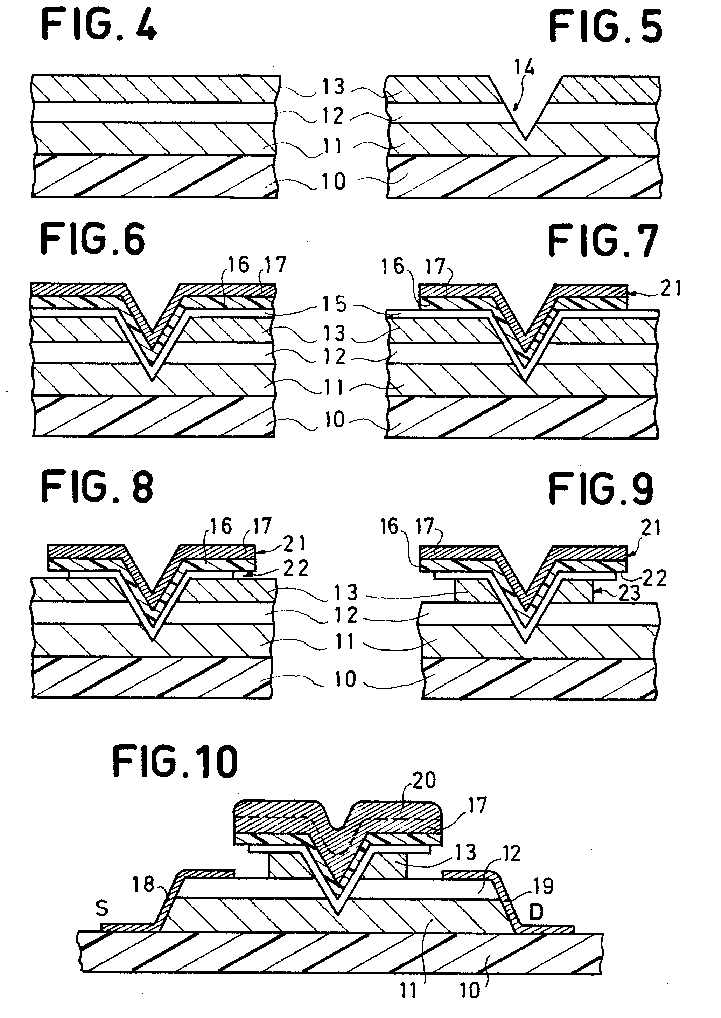

La figure 4 représente la première étape du procédé de réalisation, illustré par les figures suivantes. Sur un substrat 10, on fait croître par des techniques d'épitaxie connues de l'homme de l'art une couche tampon 11, à grand gap, une couche d'accès 12 à petit gap, et une couche complémentaire 13. En figure 5, le sillon en V 14 est creusé à travers les trois couches superficielles 11, 12 et 13. Il est creusé par le procédé qui vient d'être décrit au sujet de la figure 3. Avec des matériaux tels que InP et Ga In As, ce sillon a automatiquement un angle de 55°.

En figure 6, on a déposé à la surface de la pastille et dans le sillon en V trois couches : la couche active 15, une couche d'isolant 16 ou d'un autre matériau semiconducteur si l'on veut faire un transistor à jonction, et une métallisation 17. L'étape suivante en figure 7 consiste à délimiter par masquage le contour de l'électrode de grille 17 puis à utiliser la métallisation de grille 17 comme masque pour l'attaque de l'oxyde 16 sous-jacente. Cette attaque est facilement faite par l'acide fluorhydrique HF additionné de fluorure d'ammonium $FNH_4$ dilué. Lorsque cette attaque est terminée,

0138638

8

elle bute sous la couche sous-jacente 15 de Ga In As, ne l'attaque pas, mais laisse un bord 21 commun à la métallisation 17 et à l'oxyde 16 sous-jacent.

Pour réaliser la sous-gravure de la couche 15 de Ga In As, représentée en figure 8, on utilise une solution d'acide sulfurique H2SO4 additionnée d'eau oxygénée $H_2 O_2$ diluée dans l'eau $H_2O$. Cette solution attaque sélectivement Ga In As et la durée de l'attaque règle la longueur de la sous-gravure 22, sous la couche d'oxyde 16.

Quant à la couche 13 d'InP, sa sous-gravure, sous la couche 15 de Ga In As elle-même sous-gravée, est obtenue par un mélange d'acide chlorhydrique HCl et d'acide orthophosphorique H3PO4. Là encore la durée de l'attaque, sélective puisqu'elle bute contre la couche 12 d'InP, règle la longueur de la sous-gravure 23. De façon plus générale les solutions utilisables dans la gravure des associations InP-In Ga As P sont décrites en détails dans la revue "Chemical Etching of In Ga As P-InP, par Adachi, Noguchu et Kawaguchi, dans J. of The Electrochemical Society, volume 129, N°5, May 82, page 1054.

La figure 10 reprend presque la figure 2, mais permet de préciser que le transistor selon l'invention est achevé en taillant une mésa dans les couches 11 et 12, et en utilisant le "champignon" de grille comme masque d'auto-alignement pour le dépôt des électrodes de source et de drain. La métallisation des trois électrodes 18 de source, 19 de drain et 20 de grille se fait simultanément, le bord des électrodes 18 et 19 étant auto-aligné par rapport aux bords de l'électrode de grille 20 qui vient en sur-épaisseur par rapport à la métallisation d'origine 17.

La différenciation des couches active 15, dans laquelle est située le canal, et d'accès 12, toutes deux en GaInAs, permet la réalisation de nombreuses variantes, avec possibilité d'ajuster un plus grand nombre de paramètres de façon indépendante.

Par exemple, leur dopage conditionne la présence d'une conduction à deux dimensions de forte mobilité. Celle-ci pourra donc être limitée au canal si la compatibilité avec des composants voisins l'exige. L'épaisseur de la couche d'accès 12 influe sur les résistances d'accès donc les performances en fréquence. Celle de la couche active 15 permet le réglage de la tension de pincement, ainsi que le caractère "normalement bloqué" ou "normalement

9

passant" du transistor.

Les principales variantes à l'invention reposent sur d'autres choix possibles pour la commande électrique par la grille. L'oxyde peut être remplacé par une jonction PN ou par un contact Schottky.

Toutefois le composant peut être réalisé dans toute famille de matériaux autres que GaInAs-InP connue pour permettre la croissance d'hétérojonctions de bonne qualité, par exemple GaAlAs/GaAs.

De plus, la possibilité de le réaliser en GaInAs sur InP, un des matériaux dans lequel sont fabriqués les lasers à semiconducteurs, le rend intégrable sur une même pastille que ceux-ci et donc apte aux applications optoélectroniques.

Il est, de façon plus générale, destiné aux circuits intégrés hyperfréquences.

## REVENDICATIONS

1/ Transistor à effet de champ, à grille ultra-courte et à structure horizontale, comportant, supportées par un substrat (10), au moins une première couche (11) d'un matériau semiconducteur à grande bande interdite, recouverte par une seconde couche (12) d'un matériau semiconducteur à petite bande interdite, ces deux couches (11, 12) formant une mésa sur les flancs de laquelle sont déposées deux métallisations (18, 19) d'électrodes d'accès, source et drain, ce transistor étant caractérisé en ce que la région de contrôle, constituée par la couche active (15) et au moins la métallisation de grille (17) est formée dans un sillon (14), qui sépare la seconde couche (12) en deux régions d'accès à la couche active (15), et qui pénètre dans la première couche (11), la longueur de pénétration dudit sillon (14) dans la première couche (11) constituant la longueur $(l_1 + l_2)$ de grille du transistor.

2/ Transistor à effet de champ selon la revendication 1, caractérisé en ce que, le substrat (10) ayant une orientation cristallographique $\langle 100 \rangle$ , les première (11) et deuxième (12) couches épitaxiées ont également une orientation cristallographique 100 et le sillon (14) est axé selon l'orientation $\langle 110 \rangle$ ou $\langle 110 \rangle$, ses flancs s'appuyant sur les coupes $\langle 111 \rangle$ des couches épitaxiées (11, 12).

3. Transistor à effet de champ selon la revendication 1, caractérisé en ce qu'il comporte en outre, déposée sur la seconde couche (12) une troisième couche (13), dite couche d'isolement, en matériau semiconducteur non dopé, ladite couche (13) plaçant la couche active (15), d'une part, et les deux métallisations (18, 19) de source et drain, d'autre part, dans deux plans différents, les métallisations de grille (17) et de source et drain (18, 19) étant auto-alignées.

4/ Procédé de réalisation d'un transistor à effet de champ, à structure horizontale, selon la revendication 3, caractérisé par la suite d'opérations suivantes :

a/ sur un substrat (10) en matériau semiconducteur, coupé selon l'orientation cristallographique $\langle 100 \rangle$ ., dépôt par épitaxie d'une première (11), une deuxième (12) et une troisième (13) couches de matériau

semiconducteur, orientés $\langle 100 \rangle$ ,

b/ masquage par procédé photolithographique, en surface des couches épitaxiées (11, 12, 13) du sillon (14), selon l'axe $\langle 110 \rangle$ ou $\langle 110 \rangle$ de ces couches,

c/ creusement par voie chimique du sillon (14), au moyen d'une solution non sélective vis-à-vis des matériaux des couches (11, 12, 13) attaquées, l'attaque se faisant selon les coupes $\langle 111 \rangle$ des dites couches, le creusement traversant totalement la troisième (13) et la seconde couche (12) et partiellement la première couche (11),

d/ dépôt, dans le sillon (14) et sur la surface libre de la couche supérieure (13), d'une couche active (15), en matériau semiconducteur, d'une couche intermédiaire (16) entre couche active (15) et électrode de grille (17), par épitaxie en phase vapeur ou par jet moléculaire, et d'une couche métallique (17),

e/ délimitation, par procédé photolithographique, du contour de l'électrode de grille (17), et attaque chimique, par $HF + FNH_4$ dilué, de la couche intermédiaire (16) sous-jacente,

f/ sous-gravure chimique, par $H_2SO_4 + H_2O_2$ dilué, de la couche active (15), sous la couche intermédiaire,

g/ sous-gravure chimique, par $HCl + H_3PO_4$, de la couche d'isolement (13), sous la couche active,

h/ gravure d'une mésa dans les première (11) et seconde (12) couches, et métallisation, par pulvérisation, des électrodes (18, 19) de source et drain, en utilisant la structure de la région de contrôle (13 + 15 + 16 + 17) pour l'auto-alignement.

5/ Procédé de réalisation d'un transistor à effet de champ selon la revendication 4, caractérisé en ce que, le transistor étant à grille à jonction (JFET), la couche intermédiaire (16) entre couche active (15) et métallisation de grille (17) est une couche de matériau semiconducteur.

6/ Procédé de réalisation d'un transistor à effet de champ selon la revendication 4, caractérisé en ce que, le transistor étant à grille isolée (MISFET ou MOSFET), la couche intermédiaire (16) entre couche active (15) et métallisation de grille (17), est une couche d'oxyde.

**FIG.1**

**FIG.2**

**FIG.3**

# FIG. 4

13
12
11
10

# FIG. 5

14

# FIG.6

16 17
15
13
12
11
10

# FIG. 7

16 17
21

# FIG. 8

16 17
21
22
13
12
11
10

# FIG. 9

16 17
21
22
23

# FIG.10

20
17
13 12
18
19
S
D
11 10